# EUROPEAN PATENT SPECIFICATION

(11) **EP 3 418 851 B1**
(45) Date of publication and mention of the grant of the patent: **06.08.2025**
(21) Application number: 18159283.3
(22) Date of filing: 28.02.2018
(51) Int. Cl.: G05G 1/04, G05G 5/05, G05G 1/08, G05G 5/04, E03C 1/05, H03K 17/968

(54) **CONTROLLER**
STEUERGERÄT
ORGANE DE COMMANDE

(30) Priority: 01.03.2017 GB 201703309
(43) Date of publication of application: 26.12.2018
(73) Proprietor: AQUALISA PRODUCTS LIMITED, Westerham, Kent TN16 1DE (GB)
(72) Inventor: Euluri, Anoor, Westerham, Kent TN16 1DE (GB); Harris, Stephen, Westerham, Kent TN16 1DE (GB)
(74) Representative: J A Kemp LLP

(56) References cited:
- EP-A2- 3 054 302
- WO-A1-2009/103596
- CN-A- 104 662 801
- DE-A1- 102006 014 923
- DE-A1- 102014 010 786
- JP-A- S59 149 519
- US-A1- 2011 316 655
- US-A1- 2016 378 322

## Description

The present invention relates to a controller for a water related system, such as an electronic shower unit, and a water related system including such a controller.

Many water related systems require interaction with fluid and require the use of user-operable inputs. Many water related systems require the use of a controller to allow the user to control specific characteristics of water flow within the water related system. For example, the controller may allow a user input to control the temperature, to control the flow rate and outlet of water flow in the water related system and/or to provide inputs to navigate a menu on the controller.

It is known to provide mechanical controllers, for example, a controller operable using spring mechanisms. It is also known to use mechanical switches and buttons in mechanical controllers. Such known controllers can take up a lot of space resulting in a bulky device. There is scope for providing a controller with a user input which has improved operability and reliability and which may take up less space.

DE 10 2006 014923, US 2011/0316655 and WO 2009/103596 disclose background art.

For use in a wet environment, extra precautions must be taken to seal controllers from that environment and the user. It is known that degradation of mechanical controllers and mechanical switches and buttons over time may be expedited by a surrounding wet environment. There is scope for providing a controller which reduces the effect of the wet environment on the features of the controller relating to the user input.

According to the present invention, there is provided a controller as defined in appended claim 1.

The present invention is based on an understanding of issues relating to the use of a controller in a wet environment. The present invention provides a control unit comprising a position determining device as part of a controller configured to reduce the effect of the wet environment on the position determining device and on the durability of the controller. Control of certain characteristics of water, such as the temperature of water in a shower system, may be of high importance and may require a robust controller with a minimum required degree of accuracy. Temperature control, for example, has associated health and safety implications, thus the control of such a characteristic requires a controller which is capable of meeting minimum accuracy and durability requirements.

By providing a control unit and an input member as described above, the position determining device can be maintained in a dry environment such that the integrity of the position determining device is maintained. Additionally, the input member may be easily detached and reinserted as the controller may use magnets to keep the input member in place as well as being used to control movement of the input member. Using magnets to move the input member back to a neutral position improves the operability for the user because after each input, the input member will return to the neutral position allowing the user to then input a further input. The improved operability may also mean that the user has a pleasant inputting experience due to the feel generated by the use of at least one magnet pair as the input member is moved from the neutral position. Furthermore, degradation of mechanical switches and buttons in the controller can occur due to the wet environment meaning that motion of the input member can be impaired and it can become difficult to move the input member. However, using magnets may be more robust and may reduce such degradation and its effects making them more reliable. Additionally, the use of the magnets allows for a more simple design and advantageously, the magnets should last the whole life of the controller.

The position determining device comprises a sensor comprising an emitting unit configured to emit a signal and a detecting unit configured to detect the signal. The input member or the control unit comprises a reflector arranged to reflect the signal towards the detecting unit and the controller is configured to determine the position of the input member based on the reflected signal. In this way, signals rather than mechanical switches can be used to determine a user input. This is beneficial because it means that the use of mechanical switches, which can be more significantly affected by a wet environment than using the above described sensors, can be avoided or reduced. Additionally, mechanical switches may be bulkier than corresponding sensors and may be prone to failure, and are therefore, preferably avoided.

The sensor is optical, infrared or ultrasonic. These types of sensor may all provide signals which can be used to determine the user input. These types of sensor have the advantage that it can be optimised depending on available signal strength and signal dispersion for that type of sensor.

The use of optical, infrared or ultrasonic sensors have the advantages as described above. Signals rather than mechanical switches can be used to determine a user input. This is beneficial because it means that the use of mechanical switches, which can be more significantly affected by a wet environment and can be bulky, can be avoided or reduced. Optical, infrared or ultrasonic sensors may all provide signals which can be used to determine the user input. Each type of sensor may have the advantage that it can be optimised depending on available signal strength and signal dispersion for that type of sensor.

The input member is movable relative to the control unit between a neutral position and a displaced position or multiple displaced positions. In this way, the input member is movable relative to the control unit to predetermined positions which means that the position of the input member may be more easily and accurately determined than if the input member is expected to move to and be detected at any point with respect to the control unit.

The controller comprising a mechanical spring configured to apply a force to return the input member to the neutral position improves the operability for the user because after each input, the input member will return to the neutral position allowing the user to then input a further input.

The controller comprising at least one magnet pair configured to apply a force to return the input member to the neutral position has the advantages as described above. The at least one magnet pair may be provided additionally or alternatively to the mechanical spring. Using magnets to move the input member back to a neutral position improves the operability for the user because after each input, the input member will return to the neutral position allowing the user to then input a further input. The improved operability may also mean that the user has a pleasant inputting experience due to the feel generated by the use of at least one magnet pair to the neutral position.

Preferably, the controller comprises two magnet pairs. Providing additional magnet pairs provides greater stability because the multiple magnet pairs can be used to keep the input member in the desired place. This may be particularly useful for certain configurations where two or more magnet pairs are used to improve stability as well as feel for the user moving the input member to make an input, i.e. the use of two magnet pairs may provide a more pleasant feel that one magnet pair.

Additionally, the magnet pairs may provide slightly different functions, for example, depending on the movement of the input member, at least one of the magnet pairs may be used to keep the input member in place, i.e. substantially next to the control unit to prevent the input member from falling away from the control unit, whereas the other magnet pair may apply a force to move the input member back to the neutral position. The second magnet pair may provide a damping effect such that the connection between the input member and the control unit can be damped to provide an elastic connection.

The input member may comprise a reflector arranged to reflect the signal towards the detecting unit when the input member is in the neutral or the displaced position. Alternatively, the control unit may comprise a reflector arranged to reflect the signal towards the detecting unit and the input member comprises a non-reflecting portion configured to block reflection of the signal when the input member is in the neutral or the displaced position. Providing the reflector on the input member or the control unit allows components of the sensor to be positioned in a convenient location depending on where the signal needs to be emitted from and where the reflected signal need to be detected.

Preferably, the input relates to a desired value of the characteristic of water flow being controlled. This means that the user can use the input member to alter characteristics of water flow. This allows the user to alter the water flow such that it has the desired characteristics of the user, e.g. water temperature and/or flow rate, etc.. The input may be used to navigate menu options provided by the controller.

Optionally, the characteristic of water flow being controlled is the temperature of the water flow and/or flow rate of the water flow. It may be particularly beneficial to control these features of water flow because these may be of particular importance for a user depending on the type of water system the controller is being used for. For example, if the water system is a shower, then the control of the temperature is not only desired, it has corresponding health and safety regulations to ensure that the water is at a safe temperature that will not harm the user.

Optionally, the controller further comprises a coupling portion configured to couple the housing and the input member. In this way, the input member may be kept in position relative to other components of the controller, such as the control unit, or more particularly, the position determining device. Furthermore, this means that the housing is multifunctional in that it can be used to separate the control unit from the input member and seal the other components of the control unit whilst also keeping the input member in the desired positions.

Preferably, the input member is movable relative to the control unit between a neutral position and more than one displaced position, preferably two displaced positions, or three displaced positions, or four displaced positions or more. Having more than one predefined displaced position means that the input member may be used to input the user input in a variety of different ways. For example, the input member may be used to go up and down menu options, e.g. to select or edit a user or device profile, and/or to control a timer, and/or to alter or select a characteristic of the water in the water related device, e.g. to control the temperature.

Preferably, the controller further comprises a barrier and/or a back element configured to limit displacement of the input member. In this way, the input member is kept in place with respect to the housing and is limited to moving to certain predefined positions, i.e. the neutral position and the displaced position(s). Limiting the movement of the input member allows the displaced position(s) to be more easily defined such that the sensors will provide more reliable readings and the user input can be accurately determined. Preferably, the controller comprises a bayonet type connection between the control unit and the back element. This allows parts of the controller to be easily removed and replaced without damaging the controller or the connection. Thus, certain portions of the controller may be repaired, replaced, or customised more easily by the user.

Optionally, the control unit comprises pin connectors to provide means for electrically connecting the controller to an electricity source. This allows the electrical connection to the controller even when the control unit is rotated relative to other components of the controller. The control unit may be rotated relative to the electricity source, for example if the control unit is connected to the back element using a bayonet type connection.

Preferably, the controller further comprises a removable band around the housing. This may be switched with other bands by the user and allows the user to easily customise the controller according to their preference.

The controller may be incorporated in any appropriate water related system or device, particularly those to be situated in wet environments. The controller is particularly useful in an electrical unit. The present invention further provides a water related system comprising a controller as described above.

The invention will be more clearly understood from the following description, given by way of example only, with reference to the accompanying drawings, in which:-
Figure 1a illustrates a controller for a water related system in accordance with an embodiment, wherein an input member is in a neutral position;
Figure 1b illustrates the controller of Figure 1a wherein the input member is in a displaced position;
Figures 1c illustrates a cross section of the controller through section X-X in Figure 1b;
Figures 2a-2c illustrate variations of the barriers depicted in Figures 1a, 1b and 1c;
Figures 3-5 illustrate variations of the location of the sensor and reflector depicted in Figures 1a, 1b and 1c;
Figures 6a and 6b illustrate variations of the positions of the magnet pair depicted in Figures 1a, 1b and 1c;
Figures 7a-7c illustrate a variation of the controller depicted in Figures 1a, 1b and 1c wherein a further displaced position is depicted;
Figures 8a and 8b illustrate variations of the controller depicted in Figures 1a, 1b and 1c wherein a further magnet pair is depicted;
Figures 9a and 9b illustrate a possible connection mechanism between the control unit and the back element depicted in Figures 1a, 1b and 1c;
Figures 10a and 10b illustrate a variation of the controller depicted in Figures 1a, 1b and 1c showing the electrical pin type connections to the control unit;
   and
Figure 11 illustrates a water related system using a controller according to an embodiment.

The same references are used for similar features throughout the drawings. The features shown in the figures are not necessarily to scale and the size or arrangements depicted are not limiting. It will be understood that not all of the features of the controller are depicted on each figure and the figures may only show a few of the components relevant for a describing a particular feature.

The present invention can be useful for any water related system, especially one that requires the controller to be positioned in a wet environment, i.e. to interact with water or a very humid environment. The present invention provides a controller that can be used to control water flow in a water related system and wherein the controller can be sealed effectively from the wet environment.

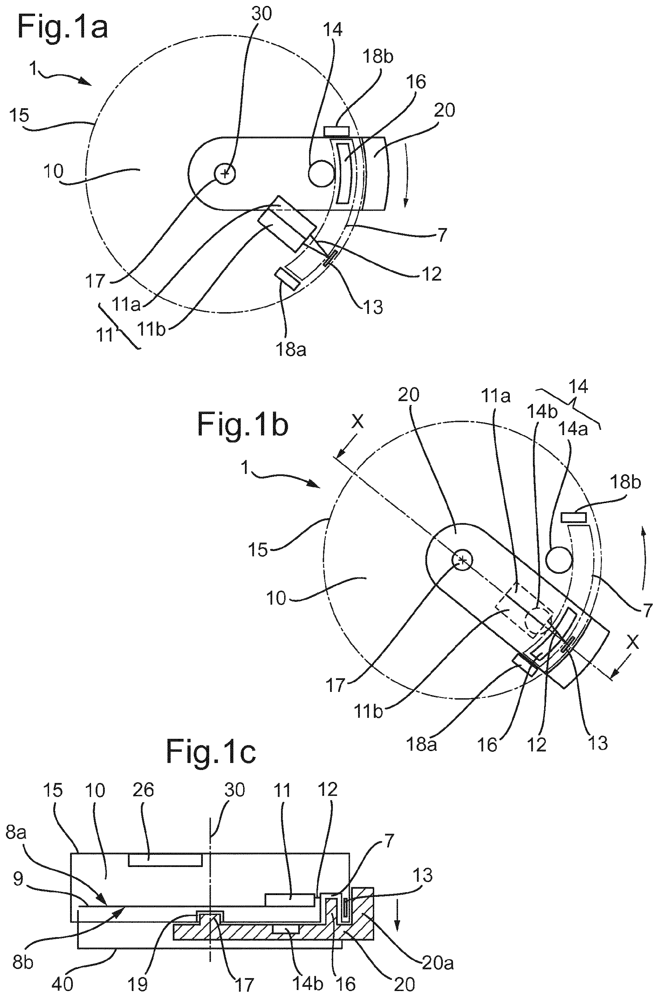

A first embodiment is provided in accordance with the invention. Figure 1a illustrates a configuration of a controller 1 in accordance with the first embodiment. The controller 1 is provided for a water related system. he controller 1 is configured to control a characteristic of water flow in the water related system. The controller 1 comprises a control unit 10 comprising a sensor 11. The controller 1 also comprises an input member 20 being moveable relative to the control unit 10 between a neutral position and displaced position. The controller 1 is configured to determine the position (i.e. the location) of the input member 20. As such, the controller 1 may determine when the input member 20 is in the neutral position and/or the displaced position. The controller 1 is configured to determine an input based on the position of the input member 20.

The controller 1 also comprises at least one magnet pair 14 configured to apply a force to the input member 20 to position the input member 20 in the neutral position. For example, the user may move the input member 20 to the displaced position and then release the input member 20, in which case, the at least one magnet pair 14 may apply a force to the input member 20 to move the input member 20 to the neutral position. In other words, the input member 20 is self-centring.

The controller 1 may determine the input based on the position of the input member 20. The input may relate to a desired value of the characteristic of water flow being controlled by the controller 1. For example, a desired set value, such as a desired temperature or a desired flow rate. Additionally or alternatively, the input may relate to various controls to navigate options, for example menu options, provided by the controller 1. For example, the input may correlate to a movement in a list of options and/or a selection of an option. The options may be displayed on a user interface 26, e.g. a display screen. The user interface 26 is depicted in Figure 1c, but may not be included in the controller 1 of Figure 1c and/or may be included in the controller depicted in any of the other figures. Thus, for example, the input may be used to navigate options to allow selection of a value of a characteristic of water flow, or may be used to navigate options relating to settings of the controller 1, such as time and date settings. The user may easily navigate the options displayed using the input member 20 to make an input. The controller 1 may determine the input from the input member 20 being moved to at least one displaced position, otherwise known as an active state.

The input member 20 may be positioned in a neutral position as shown in Figure 1a. The arrow in Figure 1 indicates the possible movement of the input member 20. The input member 20 may be moved from the neutral position to a displaced position, for example, to the displaced position as depicted in Figure 1b. Figure 1b includes an arrow showing possible movement of the input member 20 back to the neutral position as in Figure 1a. As shown in Figures 1a and 1b, the movement of the input member 20 may be a rotation of the input member 20 around a main axis 30 of the controller 1. The input member 20 may be moved to multiple displaced positions, i.e. different displaced positions may be used to indicate different inputs. Although only one displaced position may be referred to throughout the description, this is indicative of one of multiple displaced positions to which the input member 20 could be moved to.

The main axis 30 of the controller 1 may be defined as an axis approximately through the centre of the control unit 10. Thus, the main axis 30 may otherwise be referred to as a central axis. The main axis 30 is not limited to being substantially central through the control unit 10 and could be located in different positions depending on different shapes of the controller 1. The main axis 30 may be substantially perpendicular to a surface of the controller 1, for example, the main axis 1 may be approximately perpendicular to a surface of a back element 40 and/or a housing 15 of the control unit 10 (both of which are described in more detail below). The main axis may be defined as the axis around which the input member 20 rotates.

As depicted in Figures 1a and 1b the control unit 10 may further comprise the housing 15. The housing 15 is part of the control unit 10 and other components of the control unit 10 may reside within the housing 15 or may be a part of or attached to the housing 15. The input member 20 may be separate from the housing 15. This allows relative movement between the input member 20 and the control unit 10 such that the control unit 10 can be moved between a neutral position and a displaced position and can be used to determine an input as described above. The neutral position and the displaced position may thus be defined with respect to the control unit 10 and may be located in any predetermined location(s) with respect to the control unit 10. The housing 15 provides a "dry-zone", i.e. the housing 15 allows the controls and electronics of the control unit 10 to be sealed and kept separate from the wet environment, i.e. a "wet-zone". The input member 20 is located in the wet-zone whereas the controls and electronics are kept in dry-zone. This has the advantage that the electronics are kept safe in the housing, which is preferably a sealed body, whilst allowing for detection of movement of the input member 20 in the wet-zone outside the housing.

Preferably, the input member 20 is separate from the control unit 10. This allows the relative movement between the input member 20 and the control unit 10 as described above. In use, the input member 20 may be positioned adjacent to the control unit 10, or more particularly, adjacent to an outer surface of the housing 15 of the control unit 10, for example, as depicted in Figures 1a-1c. The position of the input member 20 adjacent to the control unit 10 may be maintained due to the attraction of forces between the control unit 10 and the input member 20 due to the magnet pair 14 as described below.

As depicted in Figures 1a and 1b, the control unit 10 preferably comprises at least one barrier in order to limit displacement of the input member 20. For example, barrier 18a may be provided to limit movement of the input member 20 when moving away from the neutral position, i.e. to limit movement in a same direction as the arrow in Figure 1a. This barrier 18a may prevent the input member 20 from moving to a position further away from the neutral position than the defined displaced position. The barrier 18a may be a protrusion of the housing 15 or a component attached to the outside of the housing 15. Limiting the range of movement of the input member 20 may be beneficial in that the input member 20 may be moved between a neutral position and a predetermined displaced position such that movement of the input member 20 is more easily detected. In other words, at least one barrier 18a may be used to define the displaced position.

The input member 20 should return to the neutral position due to the attractive forces between the magnets of the magnet pair 14. However, the control unit optionally comprises a further barrier 18b to also limit movement of the input member 20 to define the neutral position, i.e. to limit movement in a same direction as the arrow in Figure 1b. This helps ensure that the input member 20 is not pushed past the neutral position depicted in Figure 1a and allows the input member 20 to stay within a predetermined range in which the magnet pair 14 are known to effectively provide a force to return the input member 20 to the neutral position. In other words, when the input member is moved to between the barrier 18a and the further barrier 18b, the magnet pair 14 should provide a force to return the input member 20 to the neutral position when the user releases the input member 20. Thus, the barrier 18a and the further barrier 18b allow the input member 20 to move between two distinct positions, i.e. the neutral position and the displaced position, with a range of movement between these two positions. The further barrier 18b may be a protrusion of the housing 15 or a component attached to the outside of the housing 15.

The controller 1 comprises a magnet pair 14, for example, as depicted in Figures 1a-1c. As will be clear from Figure 1b, the magnet pair 14 comprises a first magnet 14a and a second magnet 14b. As depicted in Figure 1b, the first magnet 14a may be provided on or in the control unit 10, thus the first magnet 14a may be attached to the control unit 10. The second magnet 14b may be on or in the input member 20, thus the second magnet 14b may be attached to the input member 20. The magnet pair may be configured to apply an attractive force on one another. This has the advantage that the input member 20 is kept in position adjacent or near to the control unit 10 by the attraction of the magnet pair 14.

As depicted in Figure 1a, when the input member is in the neutral position, the first magnet 14a and the second magnet 14b are substantially aligned. When the first magnet 14a and the second magnet 14b are within a certain distance of each other, they apply attractive forces on each other. The first magnet 14a and the second magnet 14b are arranged such that the attractive forces act to position the input member 20 in the neutral position. The further barrier 18b may apply an additional force and the combination of forces due to the first magnet 14a, the second magnet 14b and the interaction of the input member 20 and the further barrier 18b may cause the input member 20 to be positioned in the neutral position in Figure 1a.

As the user moves the input member 20 in the direction of the arrow depicted in Figure 1a, the second magnet 14b is moved away from the first magnet 14a toward the displaced position depicted in Figure 1b. Thus, the first magnet 14a and the second magnet 14b are no longer aligned. Due to the position of the input member 20 in Figure 1b, the first magnet 14a and the second magnet 14b will apply an attractive force to each other to move the input member 20 from the displaced position in Figure 1b to the neutral position in Figure 1a. Thus, an external force is required to move the input member 20 from the neutral position in Figure 1a to the displaced position in Figure 1b. The external force may be applied by a user input, for example by using their hand to push down the input member 20 in the direction of the arrow in Figure 1a. When the user releases the input member 20, the first magnet 14a and the second magnet 14b attract one another to move the input member 20 back to the neutral position. Thus, user input is not required to move the input member 20 from the displaced position in Figure 1b back to the neutral position in Figure 1a because of the attractive forces of the magnet pair 14. It is noted that the controller 1 may additionally comprise a spring (not depicted) to help move the input member 20 back to the neutral position.

The position determining device may comprise a sensor 11 comprising an emitting unit 11a configured to emit a signal 12 and a detecting unit 11b configured to detect the signal 12, for example, as depicted in figures 1a-1c. As depicted in Figure 1a the control unit 10 may comprise a reflector 13 arranged to reflect the signal 12 towards the detecting unit 11b. Thus as depicted in Figure 1a, when the input member 20 is in the neutral position, the signal 12 is emitted from emitting unit 11a, the signal 12 is reflected from the reflector 13 and detected by the detecting unit 11b.

When used with a sensor 11 as described, the housing is adapted to allow the signal to pass through the housing 15 in at least one predefined location. For example, at least a part of the housing 15 is preferably transparent or translucent. The housing may comprise portions and recesses in which parts of the input member 20 may be positioned and moved and the signal 12 may pass through these portions and recesses of the housing 15 such that the housing 15 itself does not prevent the signal 12 being detected by the detecting unit 11b.

The input member 20 may comprise an input member barrier. As depicted in Figures 1a-1c for example, the input member barrier may be a protrusion 16. As the input member 20 is moved into the displaced position in Figure 1b, the protrusion 16, as part of the input member 20 moves also. The controller 1 may be arranged such that when the input member 20 is in the displaced position, the protrusion 16 prevents reflection of the signal 12. As depicted in Figure 1b, the protrusion 16 may be arranged to pass between the sensor 11 and the reflector 13 when the input member is moved to the displaced position. The protrusion 16 may be formed of, or may be coated by a non-reflecting material such that the signal 12 is not reflected and cannot be detected by the detecting unit 11b when the protrusion 16 is positioned between the sensor 11 and the reflector 13. Optionally, no barrier (such as barriers 18a and 18b) may be provided on the surface of the housing 15. Instead, movement of the input member 20 may be limited by possible movement of the protrusion 16 within the recess 7.

In this way, the signal 12 will be detected by the sensor 11 when the input member 20 is in the neutral position (Figure 1a), but the signal will not be detected by the sensor 11 when the input member 20 is in the displaced position (Figure 1b). Thus, the controller 11 may determine the position of the input member 20 depending on whether or not the signal 12 is detected by the detecting unit 11b. Furthermore, the controller 1 may then be configured to determine an input, for example a user input as described above, based on the position of the input member, i.e. based on whether or not the input member is in the neutral position or the displaced position.

As depicted in Figures 1a-1c, the sensor 11 detects the reflected signal 12 when the input member 20 is in the neutral position and the signal 12 is not detected when the input member 20 is in the displaced position. However, the controller 1 could be configured to operate in a variety of different ways for example, the controller 1 could be arranged to detect the reflected signal 12 when the input member 20 is in the displaced position. In particular, the position of the sensor 11 and the reflector 13 can be changed with respect to the control unit 10 and the input member 20 as will be described in more detail below. Generally, the input member 20 or the control unit 10 comprises the reflector 13 to reflect the signal 12 towards the detecting unit 11b. The controller 1 is configured to determine the position of the input member 20 based on the reflected signal 12 because the position of the reflector 13 with respect to the sensor 11 is known meaning that when the signal 12 is detected or is not detected, the input member 20 must be in one or other of the predetermined neutral or displaced positions and the controller can determine this due to detection or lack of detection of a signal.

As previously indicated, the input member 20 is separate from the housing 15. As such, the protrusion 16 of the input member 20 may extend or project into the housing 15. The protrusion 16 may sit within the recess 7 of a portion of the housing 15 as depicted in Figure 1c. Recess 7 is a cavity in the housing 15 configured to provide space for the protrusion 16. As is shown in Figure 1c, the input member 20 may move such that the projection passes between the emitting unit 11a of the sensor and the reflector 13 a described above. The emitting unit 11a can emit the signal 12 through the housing 15 of the control unit 10 as depicted in Figures 1a-1c, however, the signal 12 may be blocked by the protrusion 16 of the input member 20 as depicted in Figures 1b and 1c.

In this embodiment, the sensor 11 is optical, infrared or ultrasonic. Using these types of sensor allows the signal 12 to be generated by the emitting unit 11a and to be directed towards the reflector 13 and reflected such that it can be detected by the detecting unit 11b. Additionally, these types of sensor may provide a signal 12 strong enough to pass though the housing 15 to and from the reflector 13 as described above whilst still being reliably detected by the detecting unit 11b. Providing such types of sensor can be beneficial in that they do not rely on mechanical parts which may become faulty over time. Thus, they are more robust and as such can last longer and are likely to require more infrequent replacement and/or repairs than position determining devices relying on mechanical parts.

The controller 1 may optionally comprise a printed circuit board 9 and the sensor 11 may optionally be located on a printed circuit board 9 as depicted in Figure 1c. The printed circuit board 9 may be connected via any electrical connection, as described in further detail below. The printed circuit board 9 is only depicted in Figure 1c but could be included in any of the other Figures. The sensor 11 may be positioned on the printed circuit board 9. The sensor 11 may be attached to the printed circuit board 9, for example, using an adhesive.

The emitting unit 11a and the detecting unit 11b may both located on the same surface of the printed circuit board 9, for example, the emitting unit 11a and the detecting unit 11b may be located side by side, i.e. to emit and receive the signal in a plane approximately parallel to the direction of movement of the input member. However, alternatively, the emitting unit 11a could be placed on one surface of the printed circuit board 9, and the detecting unit 11b could be placed on another surface of the printed circuit board 9. For example, the emitting unit 11a could be positioned on a top surface 8a of the printed circuit board 9 and the detecting unit 11b could be positioned on a bottom surface 8b of the printed circuit board 9 (or vice versa). As such, the signal 12 may be emitted at an angle from the top surface 8a to be detected on the bottom surface 8b (or vice versa). In this context the top and bottom surface refer to the orientation depicted in Figure 1c but could in fact be any orientation depending on the positioning of the controller 1 overall. Arranging the emitting unit 11a and the detecting unit 11b on different surfaces of the printed circuit board 9 means that the detecting unit 11b can be shielded by the printed circuit board 9 from signals from other sources allowing more accurate detection of the signal 12. It will be understood that the printed circuit board 9 may be used in this way because it allows an efficient use of space within the controller 1, however other components, or a component, may be specifically placed to shield the emitter unit 11a from the detector unit 11b instead.

In this embodiment, the controller 1 may comprise a back element 40 configured to limit displacement of the input member 20. This arrangement is depicted in Figure 1c. The back element 40 may be configured to prevent movement of the input member 20 in a direction away from the control unit 10, i.e. in the direction of the arrow depicted in Figure 1c, corresponding to the direction out of the page in Figures 1a and 1b. The back element 40 may limit movement by not allowing any movement in this direction, i.e. by only allowing movement of the input member 20 in a direction perpendicular to the main axis 30 of the controller 1 (indicated by the arrows in Figures 1a and 1b), and restricting or preventing movement of the input member 20 in a direction along the main axis 30 (indicated by the arrow in Figure 1c). There may be an opening at the edge of the back element 40 (i.e. along the side of the back element 40) to allow movement of the input member 20 into the neutral position as well as the relevant displaced position(s) and the edges of the opening may be used to restrict or prevent movement of the input member 20.

The back element 40 may also be configured such that it is easily attached to a wall such that the controller 1 can be mounted on the wall. The back element 40 may comprise holes through which fitting screws can be screwed into a surface or wall in order to mount the controller 1. The back element 40 could optionally be connected to or be formed as part of the housing 15.

As described above, the input member 20 may be arranged to rotate around the main axis 30 of the controller 1. As depicted in Figure 1c, the input member 20 may comprise a coupling portion 17 configured to couple the housing 15 and the input member 20. The coupling portion 17 of the input member 20 may connect the input member 20 and the control unit 10. In this example the coupling portion 17 of the input member 20 is a circular protrusion of the input member 20 which sits within a recess portion 19 of the housing 15. The coupling portion 17 is configured to allow the input member 20 to rotate around the main axis 30 but is configured to prevent translation of the input member 20 parallel to a surface of the housing 15. Although the input member is coupled to the housing 15 using a circular protrusion as a coupling portion 17 of the input member 20 and a recess portion 19 of the housing, the coupling portion could be an opening in the input member 20 around a protrusion of the housing 15. Another exemplary coupling mechanism could be or a ball and socket joint in which the ball is a coupling portion which is located on the input member 20 or the control unit 10 and the socket portion is a coupling portion located on the other of the control unit 10 or the input member 20 respectively.

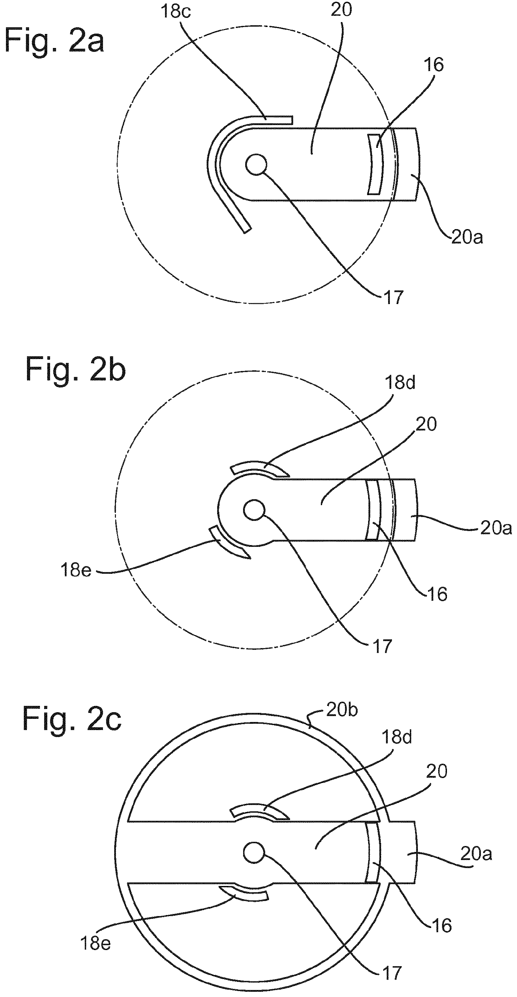

As depicted in figured 1a-1c, the input member 20 may be a lever arm and may have an elongated shape. The input member 20 could otherwise be referred to as a lever. The input member 20 may protrude from the side of the control unit 10 to allow the user to interact with the portion 20a of the input member outside of the control unit 10. The input member 20 may vary in thickness along the length of the input member 20. For example, the input member 20 may have a thicker portion 20a at the end of the input member 20 protruding form the control unit 10, as depicted in Figure 1c. The shape of the input member 20 is not limiting and various different shapes could be used. Slight variations of the elongated shape is depicted in Figures 2a and 2b. The input member 20 may comprise a circular portion 20b as depicted in Figure 2c. The circular portion 20b could be provided around the outside of the housing 15/control unit 10. Such a circular portion 20b could otherwise be referred to as a collar or bezel. The circular portion 20b may be gripped by the user to input the user input. Therefore, the input member 20 may not need a portion 20a extending out of the control unit 10, although such a portion 20a could be provided in addition to the circular portion as depicted in Figure 2c.

Arranging the controller 1 such that the input member 20 has rotational movement with respect to the control unit 10 as described above is beneficial because the input member 20 can easily move between the neutral position and the displaced position. Having rotational movement may reduce the likelihood of the input member 20 becoming stuck or difficult to move compared to if other types of movement are used. However, various methods for keeping the input member 20 in place in relation to the control unit 10 may be used. The input member 20 may be moved relative to the control unit 10 in a way that comprises translation as well as rotation. For example, the input member 20 may be translated in a plane parallel to a surface of the housing 15 of the control unit 10. In such an example, the input member 20 may have a coupling portion which fits within a guiding portion of the control unit 10 (or vice versa) to restrict movement of the input member 20 with respect to the control unit 10 in a pre-determined manner. For example, the input member 20 could move along at least one guide rail of some sort.

The magnet pair 14 comprises a first magnet 14a and a second magnet 14b. The magnets of the magnet pair 14 may be generally described as magnetic components, wherein each magnetic component comprises permanent magnetic material and/or non-permanent magnetic material (i.e. temporary magnetic material). The permanent magnetic material may be a ferromagnetic material. The non-permanent magnetic material may be paramagnetic material, diamagnetic material, soft ferromagnetic material and/or an electromagnetic material. Preferably, the magnetic component is a permanent magnet, more preferably comprising neodymium magnet material. Neodymium magnets are preferred because they are relatively strong permanent magnets which are commercially available. The location and the magnetic strength of each of the components of the magnet pair may be optimised to alter the feel for the user when they move the input member.

Different forms of the barriers 18a and 18b described above may be used to limit movement of the input member 20 with respect to the control unit 10 in the first embodiment. For example, a variation of the barriers 18a and 18b is depicted in Figure 2a in which a single barrier 18c is provided. As depicted in Figure 2a, the single barrier 18c is arranged around a central portion of the input member 20. Similarly to barriers 18a and 18b, the single barrier 18c may be a protrusion of the housing 15 or a component attached to the housing. The barrier in any of Figures 2a-2c could be used instead of one or both the barriers 18a and 18b depicted in Figures 1a-1c.

The single barrier 18c as depicted has a curved portion with the same or a similar radius as a central part of the input member 20 and has extended straight portions which limit movement of the input member 20 as it rotates around the main axis 30. The single barrier 18c is longer than the barriers 18a and 18b depicted in Figures 1a and 1b and is provided in a slightly different position. As depicted in Figure 2a, the single barrier 18c is provided near to the coupling portion 17 and may provide stability for the input member 20 to help keep it in place in the controller 1. The single barrier 2c may act as a retaining wall to help keep the input member 20 in place. The single barrier 18c could be provided in addition to at least one of the first barrier 18a and/or the second barrier 18b described above.

Further variations are depicted in Figures 2b and 2c. As in Figures 2b and 2c, a first central barrier 18d and a second central barrier 18e could be provided. Each of the first central barrier 18d and the second central barrier 18e may be positioned around a central portion of the input member 20, i.e. near to the location of the centre of rotation of movement of the input member 20. The first and second central barriers 18d and 18e may provide stability for the input member 20 to help keep it in place in the controller 1. In other words, the first and second central barriers 18d and 18e may act as a retaining wall to help keep the input member 20 in place. The first and second central barrier 18d and 18e may be arranged to prevent or limit movement of the input member 20 by making contact with the input member 20 when it reaches the neutral or displaced position respectively. The first and second central barrier can be used with an input member 20 having a variety of different shapes, for example, having a lever arm shape as in Figure 2b, or comprising a circular shaped portion 20b as in Figure 2c.

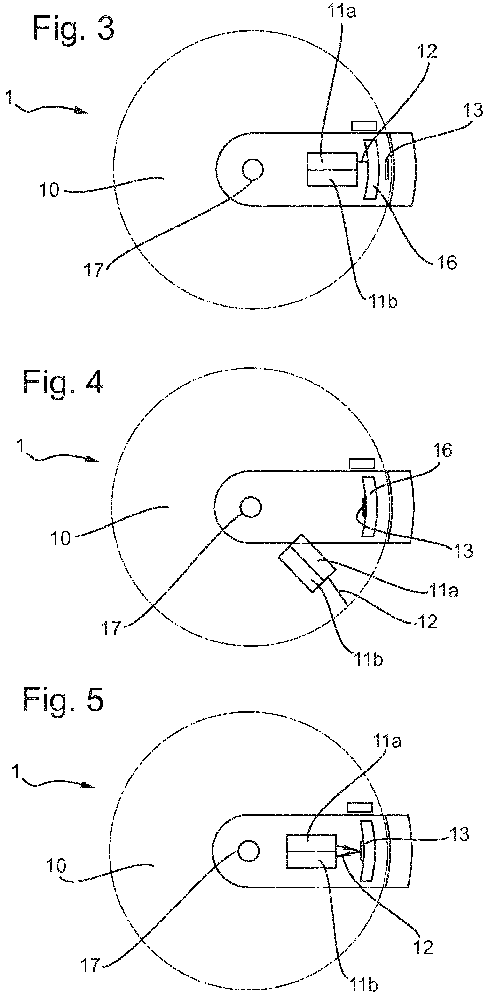

As previously described, the control unit 10 comprises a reflector 13 arranged to reflect the signal towards the detecting unit. As depicted in Figures 1a-1c, the input member 20 comprises a non-reflecting portion (protrusion 16) configured to block reflection of the signal 12 when the input member 20 is in the displaced position. Alternatively, the sensor 11 may be located differently such that the input member 20 is configured to block reflection of the signal 12 when the input member 20 is in the neutral position. For example, the sensor 11 may be located such that at least a portion of the input member 20 is positioned between the sensor 11 and the reflective portion 13 when the input member 20 is in the neutral position as depicted in Figure 3. In this way, the controller 1 may detect when the input member 20 is in the neutral position due to the lack of signal detected by the detecting unit 11b. The controller 1 may determine that the input member 20 is at the displaced position when the input member 20 is moved down and the signal 12 emitted by the emitting unit 11a is reflected from the reflector 13 and is detecting by the detecting unit 11b.

The reflector 13 is described above as being in some way part of the control unit 10. However, the reflector 13 may not be a part of the control unit. Instead, the input member 20 may comprise the reflector 13. For example, the input member 20 may comprise a projection 16 as previously described, however, the reflector 13 may be on or part of the projection 16 and may be configured to reflect the signal 12. Thus, the reflector 13 may reflect the signal 12 towards the detecting unit 11b from the input member 20. As depicted in Figure 4, the sensor 11 is located such that when the input member 20 is in the neutral position, the signal 12 emitted by the emitting unit 11a is not reflected by the reflector 13. However, when the input member 20 is pushed into the displaced position, the reflector 30 on the input member 20 will reflect the signal 12 back to the detecting unit 11b. Alternatively, the input member 20 may comprise the reflector 13 as herein described, however, the sensor may be located such that the signal 12 is reflected from the reflector 13 when the input member 20 is in the neutral position but the signal 12 is not reflected, and thus not detected, the input member 20 is in the displaced position, as depicted in Figure 5. The variations on arrangement and configuration depicted in Figures 3 to 5 could be applied to the controller 1 depicted in Figures 1a-1c.

In these examples, the input member 20 comprises a protrusion 16. However, this may not be the case. Instead, the input member may only comprise a thick end portion, for example portion 20a, wherein a reflector is located on a surface of the end portion 20a facing towards the emitting unit 11a and the detecting unit 11b. Thus, the housing would not require a recess for the protrusion 16, the position of the input member 20 could be determined depending on whether or not the signal 12 is detected as above by determining that the input member 20 is in the neutral or displaced position depending on where the sensor 11 is located.

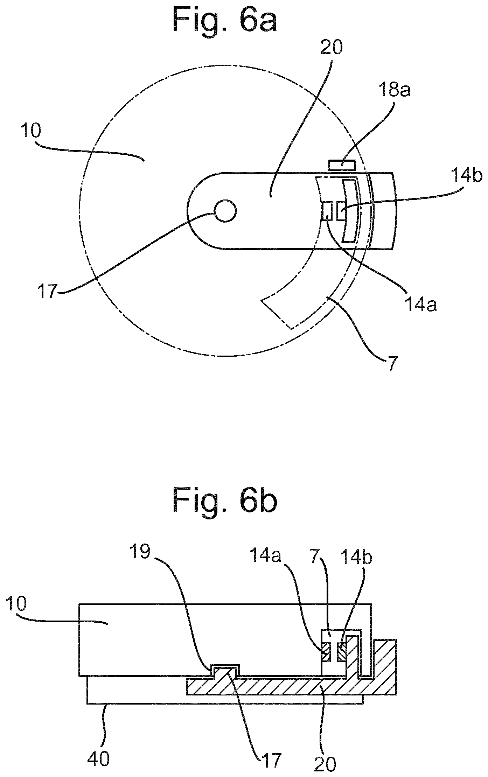

The magnet pair 14 may be oriented relative to each other in various configurations. The magnet pair 14 may be positioned such that the magnets have dipoles which are parallel to each other and the direction of relative movement between the input member 20 and the control unit 10. In other words, the magnets of the magnet pair 14 may be configured such that the magnetic field between the magnets of the magnet pair is substantially perpendicular to the direction of relative movement between the input member 20 and the control unit 10. For example, as depicted in Figure 1c, at least one magnet may be located on the input member 20, the magnet having a face substantially parallel to the face of the other magnet of the magnet pair 14. In Figure 1c, the surfaces of the magnets facing each other are substantially parallel to the direction of relative movement between the input member 20 and the control unit 10. Alternatively, the magnet pair 14 may be arranged in a configuration in which the faces of the magnets are not parallel to the direction of travel. For example, the magnet pair may preferably be positioned such that the magnetic field is perpendicular to the direction of travel and the magnet surfaces facing each other be perpendicular to the direction of travel. For example, Figures 6a and 6b depict a magnet pair 14 positioned parallel to the main axis 30. This allows the magnets to be conveniently located on the input member 20 and the control unit 10. The magnet pair 14 can be located at any angle which allows the magnet pair 14 to exert a force to move the input member 20 back to the neutral position.

In the first embodiment, the input member 20 may be moveable relative to the control unit 10 from the neutral position to more than one displaced position. As described above, the neutral position is the position at which the input member 20 returns to when the user is no longer applying a force to the input member 20. Thus the neutral position is the arrangement of the input member 20 with respect to the control unit 10 when no user is making an input. As described above in relation to Figures 1 and 2, at least one barrier may be provided to prevent and limit movement of the input member 20 with respect to the control unit 10. However, the configuration of these barriers (and the recess 7) may allow more than one displaced position.

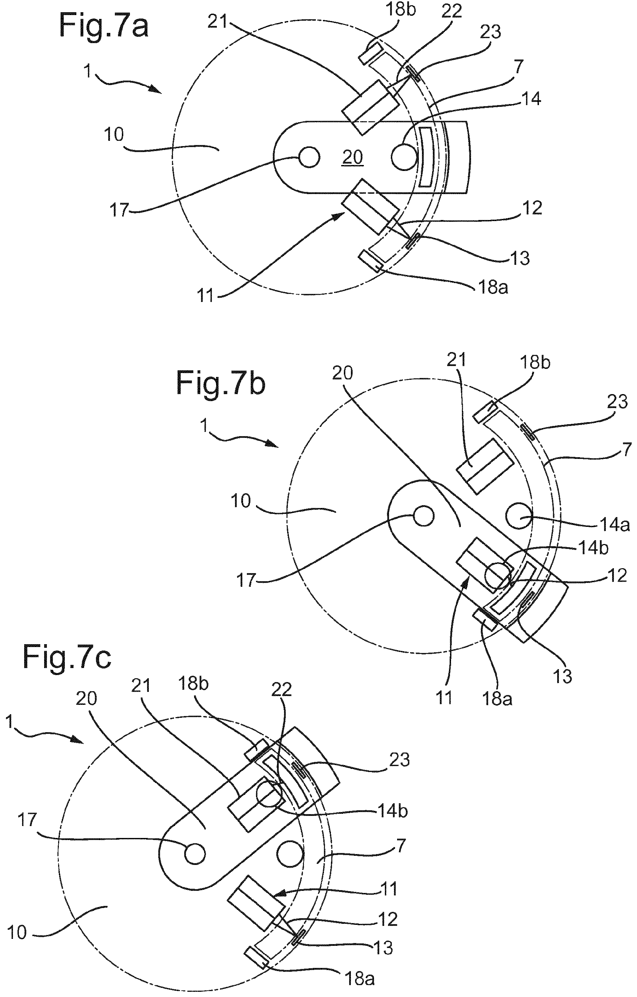

For example, this is depicted in Figures 7a, 7b and 7c. Figures 7a and 7b correspond to Figures 1a and 1b respectively. Figures 7a and 7b differ from Figures 1a and 1b respectively in that the second barrier 18b is now positioned further away from the first magnet 14a of the control unit 10 and the recess 7 is larger to allow a larger range of movement of the input member 20. In Figures 7a-7c, the input member 20 will return to the neutral position due to the presence of the magnet pair 14. Thus, the barrier 18b is no longer provided in the same way to limit movement of the input member past the neutral position in a direction away from the displaced position.

As depicted in Figure 7a, 7b and 7c the input member may be configured to move to a first displaced position and a second displaced position. The first barrier 18a may be positioned to limit displacement of the input member 20 in a first direction as depicted in Figure 7b. This may correspond to the displaced position described above in relation to Figure 1a, 1b and 1c. However, as shown in figure 7c, the input member 20 may additionally be configured to be moved to a displaced position on either side of the neutral position. Thus, the input member 20 may be moved to a second displaced position as depicted in Figure 7c. The controller depicted in Figures 1a-1c may only have a displaced position corresponding to the second displaced position in Figure 7c, or may be moved to multiple displaced positions as indicated in Figures 7a-7c.

In the first embodiment, any number of sensors may be used to determine the position of the input member 20. For example, an additional sensor could be used in Figure 1a which may emit a signal 12 which is blocked when the input member 20 is in the neutral position. Providing the same number of sensors as total positions (i.e. the number of displaced positions as well as the neutral position) means that if a sensor becomes damaged or needs repair, the controller 1 should still function due to the signals received from the remaining sensors. Furthermore, this might allow sensor damage to be detected because if all the sensors are expected to detect a reflected signal except for when the input member 20 is located in a corresponding position, then there should only be one sensor at any one time indicating that no signal is detected. Thus, if two sensors indicate that no signal is detected then this indicates an error in at least one of the sensors.

As the number of possible displaced positions is increased, the number of sensors may be increased also. Only one sensor may be used to detect the position of the input member 20 between a neutral and a single displaced position. However, for two displaced positions, two sensors may be used. As explained in relation to Figures 7a, 7b and 7c, when the input member 20 can move to a further, i.e. a second, displaced position, in order to determine whether or not the input member 20 is in the second displaced position, a further sensor 21 is included. The further sensor 21 may be the same type or a different type from the sensor 11 previously described. For example, the further sensor 21 may be optical, infrared or ultrasonic.

As depicted in Figure 7a, when the input member 20 is located in the neutral position, the signal 12 is reflected from reflector 13 and detected by sensor 11 and the further signal 22 is reflected from the further reflector 23 and is detected by the further sensor 21. As depicted in Figure 7b, when the input member 20 is moved to the first displaced position, the input member blocks the signal 12 and sensor 11 no longer detects signal 12. Further signal 22 is not blocked by the input member and the further sensor 21 detects the further signal 22. Thus, the controller 1 can determine that the input member 20 is blocking the signal 12 and is in the first displaced position. As depicted in Figure 7c, when the input member 20 is moved to the second displaced position, the sensor 11 detects the signal 12. However, the input member 20 blocks the further signal and the further sensor 21 does not detect the further signal 22. The sensor 11, further sensor 21, reflector 13 and further reflector 23 can be placed in different configurations to determine the position of the input member 20.

The input member 20 may be moved to further displaced positions, for example, three displaced positions, four displaced positions or more. For example, this may include pushing the input member 20, i.e. pushing the input member downwards in Figure 1c into a further displaced position which equates to pulling the input member 20 upwards out of the page in Figures 1a and 1b. This may require an additional sensor to determine if the input member has been pushed backwards. The back element 40 is previously described as being configured to restrict and/or prevent movement of the input member 20 away from the control unit 10. The back element 40 may be configured to restrict movement of the input member 20 but allow a limited range of movement of the input member 20 away from the control unit 10.

Furthermore, the input member 20 may be pulled forwards (i.e. pushed into the page in Figures 1a and 1b). The housing 15 may be configured to provide space for the movement of the input member 20 relative to the control unit 10 to move in the directions of the various displaced positions. There may be additional displaced positions corresponding to forward and backward positions at each of the first and second displaced positions previously described. As such, there could be a forward first position, a first position, a backward first position, a forward neutral position, a neutral position, a backward neutral position, a forward second position, a second position, and a backward second position or any combination of these possible positions. Including the neutral position, there may be n possible positions, wherein n is a discrete number. Thus, the input member 20 may be moved to a plurality of displaced positions and these may be used to input information to the controller 1 by the user in a variety of different ways. The reference to the first position and the second position may be interchangeable. There may be an equal number of sensors to the number of displaced states or one fewer sensors than displaced states. Preferably, there may be n-1 sensors, or as described in more detail below, at least n-1 emitting units.

As described, the controller 1 may comprise at least one sensor 11 comprising an emitting unit 11a and a detecting unit 11b. The sensor 11 may not be a single unit as depicted, but may be two separate components, i.e. the emitting unit 11a and the detecting unit 11b, wherein the combined units are configured to sense a signal 12 as described. As described, the controller 1 may comprise more than one sensor. The controller 1 may comprise at least one sensor and may additionally comprise at least one additional emitting unit 11a and/or detecting unit 11b. Thus, the controller 1 may have uneven numbers of emitting units and detecting units. For example, two detecting units may be used for detecting a signal emitted from one emitting unit. However, it may be preferable to have the same number of emitting units and detecting units because that may be more reliable than sensing one signal from two different locations.

The housing 15 may comprise a side recess along at least a part of the edge of the housing 15. In other words, the housing 15 may have an opening to allow for movement of the input member 20. The side recess may allow movement of the input member 20 into the neutral position as well as the relevant displaced position(s). In particular, the side recess may be provided if at least one of the displaced positions is in a direction upwards, i.e. opposite to the arrow in Figure 1c.

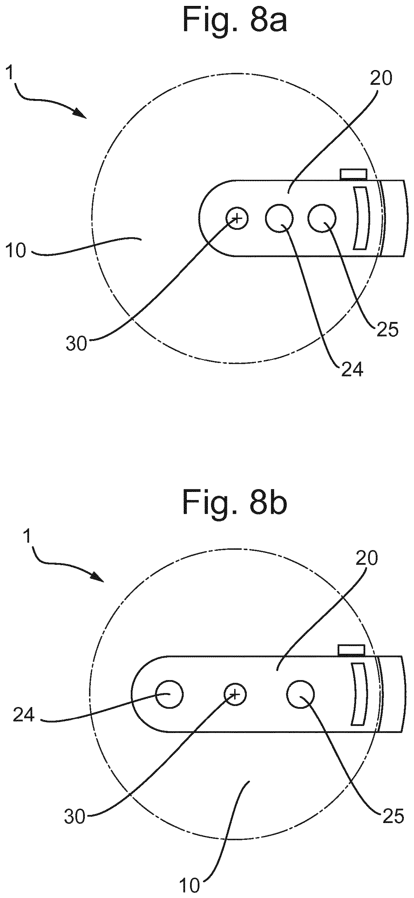

In the first embodiment, the controller 1 may preferably comprise more than one magnet pair. As depicted in Figures 8a and 8b, the controller 1 may comprise a first magnet pair 24 and a second magnet pair 25. Thus, additional magnet pairs as herein described may be provided in Figures 1a-1c. For each magnet pair, one of the magnets may be located on or in the input member 20 and the other magnet may be located on or in the control unit 10. Both the magnet pairs 24 and 25 may be located between the main axis 30 and the outer portion of the input member as depicted in Figure 8a. Alternatively, one magnet pair may be located on either side of the main axis 30 as depicted in Figure 8b. This provides additional support due to the presence of a magnet pair 24 at the back end of the input member 20. This allows the magnet pair 24 to damp movement of the input member 20 to improve feel for the user. Thus, the magnet pair 24 advantageously may have dual operation. It may act as an additional support to the input member 20 and may act as a damper to movement of the input member 20.

Using magnets means that the input member 20 can be kept approximately in place adjacent to the control unit 10. In other words, an advantage of the magnet pair is that they keep the input member 20 and the control unit 10 together. This also means that the controller 1 can be easily taken apart when desired. For example, it is possible for the user to remove the input member 20 and easily replace the input member 20 and reassemble the controller 1. This means that the controller 1 can be easily taken apart and put back together because the input member is easily removable due to the use of the magnets. This means that components of the controller 1, e.g. band 60 described in further detail below, can be exchanged and can be selected based on colour and/or finish to allow the user to customise the controller 1.

The controller 1 may detect when the input member 20 is held in at least one of the displaced positions for an extended period of time. For example, the extended period of time may be a few seconds, e.g. 2 seconds or 3 seconds or more. Thus, the controller 1 may determine the period of time that the input member 20 is held at a displaced positon from the signals detected at the available sensors described above. Based on this, the controller 1 may determine the user input to be different from when the user simply moves the input member 20 to a displaced position then releases the input member 20. For example, the user input member 20 being held in a particular displaced position may be interpreted as an input to scroll through a menu of the controller 1, or continuously change the value of a characteristic of the water in the system until the user releases the input member 20 and it returns to the neutral position. It is noted that this may be displayed to the user via a controller display (not depicted). The controller display may provide a representation of the input to the user.

In the first embodiment, the magnet pair is generally described as two magnets as indicated above. As previously described, these magnets are arranged to provide an attractive force on one another. In other words, the magnets are arranged to be drawn towards one another. However, alternatively, the components of the magnet pair could be arranged to repel one another. For example, a first magnet could be arranged on or in the control unit 10 at or near the first displaced position. The input member 20 may comprise a second magnet arranged to repel the first magnet located on or in the control unit 10. The control unit 10, and optionally also the backing element 40, may be configured to keep the input member 20 positioned between the neutral position and the first displaced position such that when the user releases the input member 20 at the first displaced position the input member 20 is repelled towards the neutral position. At least one barrier (as previously described) may be used in this instance to prevent the input member 20 being repelled further and moving away from the neutral position.

As previously described, there may be more than one magnet pair. The magnet pairs may all be attracting magnet pairs (i.e. comprising magnets arranged to attract one another). Alternatively, the magnet pairs may all be repelling magnet pairs (i.e. comprising magnets arranged to repel one another). Alternatively, the magnet pairs may be a combination of attracting magnet pairs and repelling magnet pairs, e.g. one attracting magnet pair and one repelling magnet pair.

As described, the controller 1 may comprise a back element 40. In the description above, the magnet pairs 14, 24 and 25 are located on or in the input member 20 and on or in the control unit 20. Alternatively, it may be possible to provide the magnet pair 14, 24 or 25 such that one magnet is located on or in the input member 20 and the other corresponding magnet is located on or in the back element 40. The input member 20 may still move as previously described to alter the signal detected by the sensor 11 however, the movement of the input member 20 between the neutral position and the displaced position may be affected by magnets on the back element. Additionally or alternatively, the barriers referred to in relation to the control unit 10 may additionally or alternatively be provided on the back element to help control movement of the input member 20 relative to the control unit 10. The barriers on the back element 40 may only provide control when the control unit 10 and input member 20 are positioned ready for use with respect to the back element 40.

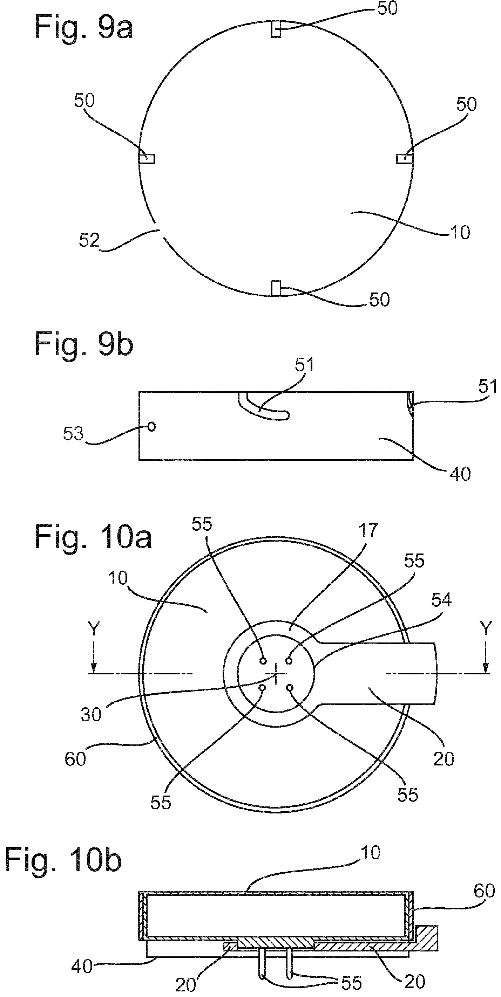

The back element 40 can be connected to a surface, for example, a wall. The back element 40 may be connected to the control unit 10 via at least one detachable connection. In other words, the back element 40 may be connected to the controller 1 via a connection which allows the control unit 10 to be detached without damaging the connection, the back element 40 or the control unit 10. The back element 40 may be connected to the control unit 10 using a bayonet type connector. In other words, the control unit 1 may have radial pins 50 (i.e. a male component) as depicted in Figure 9a which sit within a guided L-shaped slots 51 in the back element 40 (i.e. a corresponding female component) as depicted in Figure 9b. Alternatively, the control unit 10 may have radial pins and the back element 40 may have guided L-shaped slots. Having a bayonet type connector may make it particularly easy for the user to remove the control unit 10 as and when required, for example, for maintenance. Using the bayonet type connector means that the control unit 10 can be rotated relative to the back element 40 to fix the control unit 10 into place. When in position, with the input member 20 positioned between the control unit 10 and the back element 40, the input member 20 can be used to rotate the control unit 10 into position with respect to the back element 40. Additionally or alternatively, there may be at least one screw hole 52 provided in the control unit 10 and at least one screw hole 53 provided in the back element 40 to allow a screw to be positioned to removably fix the back element 40 to the control unit 10. Thus, the controller 1 may be connected to a surface or wall via the back element 40.

Providing such a bayonet type of connection between the back element 40 and the control unit 10 may mean that electrical connections between components in the control unit 10 have to allow for rotation between the relative parts of the controller 1. To address this, the back element 40 may comprise at least one opening 54, preferably substantially centrally, to allow an electrical connection. The control unit 10 may comprise pin connectors 55 protruding from the housing 15 to provide means for electrically connecting the controller to an electricity source, such as the mains. Figures 10a and 10b depict the back element 40 in place with respect to the control unit 10 wherein the pins 55 protrude from the housing to make an electrical connection. The features of Figures 10a and 10b only depict some of the features of the controller but these features could be used in combination with the features previously described for the other figures. Figure 10b depicts a cross-section through Y-Y in Figure 10a. To allow for this electrical connection from the control unit 10, the coupling portion 17 of the input member 20 may comprise a circular opening 54 around the housing of the control unit 10. In other words, the input member 20 may comprise an opening 54 through which the electrical connections can pass. As depicted in Figure 10a, the input member opening 54 may be positioned around the central axis 30 and may be the location around which the input member 20 rotates.

The controller 1 may comprise a band 60 around the housing 15 or comprising part of the housing 15. The band 60 may be removable and may form part of the casing for the controller 1. The band 60 may be interchangeable with other bands in order to alter the appearance of the controller 1. The band 60 may be positioned around the outside of the housing 15 as depicted in Figures 10a and 10b, like a bezel, or around the inside of the housing 15. In this case, the housing 15 may be transparent or translucent at least part of the way around the outside of the controller 1 to allow the band 60 to be seen by the user. The band 60 may be kept in place when the control unit 10 is fastened to the back element 40. The band 60 may be removable and may be easily changed due to the bayonet type connector described above.

The controller 1 may be provided as a kit of parts comprising the control unit 10, the input member 20 and the back element 40, described in any of the above variations, and optionally at least one band 60, or preferably several bands which are interchangeable with each other.

Providing the bayonet type connection described above means that it is not necessary to undo several layers of fixings and potentially damaging water seals, disturbing connections and invalidating any warranty to replace, repair and/or customise any components, i.e. the band 60, control unit 10 or components of the control unit 10, and/or the input member 20. Furthermore, the controller 1 having a separate input member 20 to the control unit 10 and being connectable as described means that controller 1 can be relatively easily taken apart and put back together.

The position determining device could comprise a magnet and rely on the Hall Effect. However, this is less desirable as it may affect the use of the magnet pair used to position the input member 20.

A second embodiment may be provided in accordance with the invention. The second embodiment may be the same as the first embodiment, including any previously described variations, however, instead of having a sensor with a reflector, the sensor may be replaced with another type of position determining device. For example, the position determining device may comprise a mechanical portion, such as a button, or an electrical connection made when the input member 20 is moved. As such the position determining device may be used to determine the position of the input member 20 in a similar way to as in the first embodiment. As such a single determining device may be used to determine the position of the input member 20 between the neutral position and a displaced position. Additional position determining devices may be used instead of multiple sensors described above, for example, if the input member 20 is moved to multiple different displaced positions. Additionally, a combination of different types of position determining devices described above may be used, e.g. at least one sensor used in combination with at least one button.

In a third embodiment, the controller 1 may be the same as in any of the above described embodiments, except that the controller 1 may not may not comprise any magnet pairs. The third embodiment may be the same as the first or second embodiment, including any previously described variation, except for the inclusion of the described magnet pairs. The controller may not be configured to return the input member 20 to a neutral position when the input member 20 is moved to a displaced position. Alternatively in the third embodiment, a different mechanism may be used to return the input member 20 to the neutral position, for example, the controller 1 may comprise at least one spring to control the position of the input member 20.

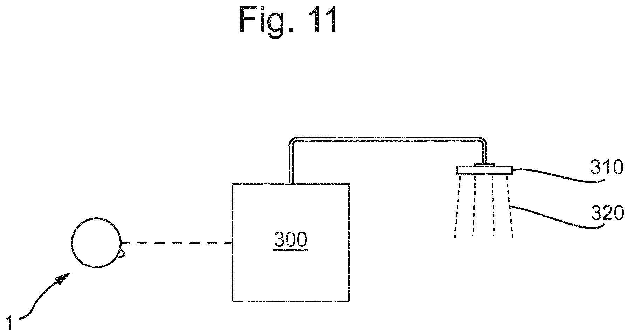

As previously described, the controller 1 may be part of a water related system. Thus, the present invention provides a water related system using the controller as described above in any of the above embodiments. The water related device may be used to implement the change indicated by the input of the user determined by the controller 1. For example, the user may push the input member to a displaced position to increase or reduce desired flow rate and/or temperature. The relevant change of the characteristic required may be determined by the controller 1 and a signal may be sent to a shower control unit 300 for example, as depicted in Figure 11. The shower control unit 300 may comprise a boiler or a heater. The shower control unit 300 may then alter the temperature of the water 320 which is provided to the showerhead 310. Thus, the user may vary the characteristic of water flow to alter the characteristic to a desired value.

The present invention may be particularly useful when applied to an electronic shower unit, for example a digital shower unit. An exemplary electronic shower unit is depicted in Figure 11. However, it would be understood that the controller 1 may be used to for a variety of different water related systems. For example, the water related system could instead refer to a bathroom tap, a kitchen tap, an instantaneous water heater (such as an electric shower unit), bath or a lavatory. The controller 1 may be part of a smart home water system control, for example, to control a sanitary unit. The controller 1 may control an outlet of water flow, e.g. in a handset, on a rail, a fixed hear and/or a bath fill.

The neutral position described above may be in various different locations with respect to the controller 1. Although the images depict the neutral position when the input member is approximately horizontal, this is not necessary and the neutral position may be in another location. Similarly, although Figure 1b shows the displaced position as a position downward of the neutral position, it will be understood that this is representative of any displacement of the input member 20 from the neutral position. Thus, the displaced position could be above the neutral position, or forward or backward from the neutral position, i.e. with the input member 20 moving out of or into the page respectively. The same applies to further described displaced positions which may be located at different positions depending on the range of possible movement of the input member 20 with respect to the control unit 10.

The orientation depicted and referred to in the description and drawings are used for reference only and for the purposes of explaining the invention. It will be understood that the orientation of the controller will depend on how the controller 1 is used and how it may be attached to or resting on an object or surface. The controller 1 may be fixed in a variety of ways.

## Claims

1. A controller (1) for a water related system, the controller (1) being configured to control a characteristic of water flow in the water related system, the controller (1) comprising:
a control unit (10) comprising a sensor (11) and a housing (15), the sensor (11) comprising an emitting unit (11a) configured to emit a signal (12) and a detecting unit (11b) configured to detect the signal (12), wherein the sensor (11) is optical, infrared or ultrasonic; and
an input member (20) arranged to rotate around a main axis of the controller (1) and being rotationally movable relative to the control unit (10), the input member (20) or the control unit (10) comprising a reflector (13) arranged to reflect the signal towards the detecting unit (11b), wherein the input member (20) is separate from the housing (15) and moves independently of the control unit (10), the environment in the housing (15) of the control unit (10) being controlled to reduce the impact of the surrounding wet environment on the sensor (11), and the components of the control unit (10) being sealed within the housing (15) and therefore protected from the wet environment;
wherein the input member (20) is movable relative to the control unit (10) between a neutral position and a displaced position or multiple displaced positions, the movement of the input member (20) being rotation of the input member (20) around the main axis of the controller (1);
wherein the controller (1) is configured to determine the position of the input member (20) based on the reflected signal; and
wherein the controller (1) is configured to determine an input based on the position of the input member (20);
further comprising at least one of: a mechanical spring configured to apply a force to return the input member (20) to the neutral position and at least one magnet pair (14) configured to apply a force to return the input member (20) to the neutral position.

2. The controller (1) of claim 1, wherein the controller (1) comprises two magnet pairs.

3. The controller (1) of claim 1 or 2, wherein the input member (20) comprises a reflector (13) arranged to reflect the signal towards the detecting unit (11b) when the input member (20) is in the neutral or the displaced position.

4. The controller (1) of claim 1, 2 or 3, wherein the control unit (10) comprises a reflector (13) arranged to reflect the signal towards the detecting unit (11b) and the input member (20) comprises a non-reflecting portion (16) configured to block reflection of the signal when the input member (20) is in the neutral or the displaced position.

5. The controller (1) of any one of the previous claims, wherein the input relates to a desired value of the characteristic of water flow being controlled.

6. The controller (1) of any one of the previous claims, wherein the input is used to navigate menu options provided by the controller (1).

7. The controller (1) of any one of the previous claims, further comprising a coupling portion (17) configured to couple the housing (15) and the input member (20).

8. The controller (1) of any one of the previous claims, wherein the input member (20) is movable relative to the control unit (10) between a neutral position and more than one displaced position, preferably two displaced positions, or three displaced positions, or four displaced positions.

9. The controller (1) of any one of the previous claims, further comprising a barrier (18a, 18b, 18c, 18d, 18e) configured to limit displacement of the input member (20).

10. The controller (1) of any one of the previous claims, wherein the characteristic of water flow being controlled is the temperature of the water flow and/or flow rate of the water flow.

11. The controller (1) of any one of the previous claims, further comprising a back element (40) configured to limit displacement of the input member (20).

12. The controller (1) of claim 11, wherein the controller comprises a bayonet type connection between the control unit (10) and the back element (40).

13. The controller (1) of any one of the previous claims, wherein the control unit (10) comprises pin connectors (55) to provide means for electrically connecting the controller (1) to an electricity source.

14. The controller (1) of any one of the previous claims, further comprising a removable band (60) around the housing (15).

15. A water related system comprising a controller (1) in accordance with any one of claims 1 to 14.

## Patentansprüche

1. Steuerung (1) für ein wasserbezogenes System, wobei die Steuerung (1) konfiguriert ist, um eine Eigenschaft von Wasserfluss im wasserbezogenen System zu steuern, wobei die Steuerung (1) Folgendes umfasst:
eine Steuereinheit (10), umfassend einen Sensor (11) und ein Gehäuse (15), wobei der Sensor (11) eine Sendeeinheit (11a), die konfiguriert ist, um ein Signal (12) auszusenden, und eine Erfassungseinheit (11b) umfasst, die konfiguriert ist, um das Signal (12) zu erfassen, wobei der Sensor (11) ein optischer, Infrarot- oder Ultraschallsensor ist, und
ein Eingabeelement (20), das angeordnet ist, um sich um eine Hauptachse der Steuerung (1) zu drehen, und drehbar relativ zu der Steuereinheit (10) bewegt werden kann, wobei das Eingabeelement (20) oder die Steuereinheit (10) einen Reflektor (13) umfasst, der angeordnet ist, um das Signal zur Erfassungseinheit (11b) zu reflektieren, wobei das Eingabeelement (20) separat von dem Gehäuse (15) ist und sich unabhängig von der Steuereinheit (10) bewegt, wobei die Umgebung im Gehäuse (15) der Steuereinheit (10) gesteuert wird, um die Auswirkung der umgebenden feuchten Umgebung am Sensor (11) zu verringern, und wobei die Komponenten der Steuereinheit (10) im Gehäuse (15) abgedichtet sind und somit vor der feuchten Umgebung geschützt sind;
wobei das Eingabeelement (20) relativ zur Steuereinheit (10) zwischen einer neutralen Position und einer versetzten Position oder mehreren versetzten Positionen bewegt werden kann, wobei die Bewegung des Eingabeelements (20) Drehung des Eingabeelements (20) um die Hauptachse der Steuerung (1) herum ist;
wobei die Steuerung (1) konfiguriert ist, um die Position des Eingabeelements (20) basierend auf dem reflektierten Signal zu bestimmen; und
wobei die Steuerung (1) konfiguriert ist, um eine Eingabe basierend auf der Position des Eingabeelements (20) zu bestimmen;
ferner umfassend mindestens eines aus Folgendem: eine mechanische Feder, die konfiguriert ist, um eine Kraft auszuüben, um das Eingabeelement (20) zur neutralen Position zurückzubringen, und mindestens ein Magnetpaar (14), das konfiguriert ist, um eine Kraft auszuüben, um das Eingabeelement (20) zur neutralen Position zurückzubringen.

2. Steuerung (1) nach Anspruch 1, wobei die Steuerung (1) zwei Magnetpaare umfasst.

3. Steuerung (1) nach Anspruch 1 oder 2, wobei das Eingabeelement (20) einen Reflektor (13) umfasst, der angeordnet ist, um das Signal zur Erfassungseinheit (11b) zu reflektieren, wenn das Eingabeelement (20) in der neutralen oder der versetzten Position ist.

4. Steuerung (1) nach Anspruch 1, 2 oder 3, wobei die Steuereinheit (10) einen Reflektor (13) umfasst, der angeordnet ist, um das Signal zur Erfassungseinheit (11b) zu reflektieren, und das Eingabeelement (20) einen nicht reflektierenden Abschnitt (16) umfasst, der konfiguriert ist, um Reflexion des Signals zu blockieren, wenn das Eingabeelement (20) in der neutralen oder der versetzten Position ist.

5. Steuerung (1) nach einem der vorhergehenden Ansprüche, wobei sich die Eingabe auf einen erwünschten Wert der Eigenschaft von Wasserfluss bezieht, die gesteuert wird.

6. Steuerung (1) nach einem der vorhergehenden Ansprüche, wobei die Eingabe verwendet wird, um Menüoptionen zu navigieren, die durch die Steuerung (1) bereitgestellt werden.

7. Steuerung (1) nach einem der vorhergehenden Ansprüche, ferner umfassend einen Kopplungsabschnitt (17), der konfiguriert ist, um das Gehäuse (15) und das Eingabeelement (20) zu koppeln.

8. Steuerung (1) nach einem der vorhergehenden Ansprüche, wobei das Eingabeelement (20) relativ zur Steuereinheit (10) zwischen einer neutralen Position und mehr als einer versetzten Position bewegt werden kann, bevorzugt zwei versetzten Positionen oder drei versetzten Positionen oder vier versetzten Positionen.

9. Steuerung (1) nach einem der vorhergehenden Ansprüche, ferner umfassend eine Barriere (18a, 18b, 18c, 18d, 18e), die konfiguriert ist, um ein Verschieben des Eingabeelements (20) einzuschränken.

10. Steuerung (1) nach einem der vorhergehenden Ansprüche, wobei die Eigenschaft von Wasserfluss, die gesteuert wird, die Temperatur des Wasserflusses und/oder die Fließgeschwindigkeit des Wasserflusses ist.

11. Steuerung (1) nach einem der vorhergehenden Ansprüche, ferner umfassend ein Rückenelement (40), das konfiguriert ist, um ein Verschieben des Eingabeelements (20) einzuschränken.

12. Steuerung (1) nach Anspruch 11, wobei die Steuerung eine bajonettartige Verbindung zwischen der Steuereinheit (10) und dem Rückenelement (40) umfasst.

13. Steuerung (1) nach einem der vorhergehenden Ansprüche, wobei die Steuereinheit (10) Stiftanschlüsse (55) umfasst, um Mittel zum elektrischen Verbinden der Steuerung (1) mit einer Stromquelle bereitzustellen.

14. Steuerung (1) nach einem der vorhergehenden Ansprüche, ferner umfassend ein lösbares Band (60) um das Gehäuse (15) herum.

15. Wasserbezogenes System, umfassend eine Steuerung (1) gemäß einem der Ansprüche 1 bis 14.

## Revendications

1. Dispositif de commande (1) pour un système en rapport avec l'eau, le dispositif de commande (1) étant conçu pour commander une caractéristique d'écoulement d'eau dans le système en rapport avec l'eau, le dispositif de commande (1) comprenant :
une unité de commande (10) comprenant un capteur (11) et un boîtier (15), le capteur (11) comprenant une unité d'émission (11a) conçue pour émettre un signal (12) et une unité de détection (11b) conçue pour détecter le signal (12), le capteur (11) étant optique, infrarouge ou à ultrasons, et
un élément d'entrée (20) agencé pour tourner sur un axe principal du dispositif de commande (1) et pouvant être déplacé par rotation par rapport à l'unité de commande (10), l'élément d'entrée (20) ou l'unité de commande (10) comprenant un réflecteur (13) agencé pour réfléchir le signal vers l'unité de détection (11b), l'élément d'entrée (20) étant séparé du boîtier (15) et se déplaçant indépendamment de l'unité de commande (10), le milieu ambiant dans le boîtier (15) de l'unité de commande (10) étant commandé pour réduire l'impact du milieu ambiant humide sur le capteur (11), et les composants de l'unité de commande (10) étant disposés hermétiquement à l'intérieur du boîtier (15) et donc protégés du milieu ambiant humide ;
ledit élément d'entrée (20) étant mobile par rapport à l'unité de commande (10) entre une position neutre et une position déplacée ou de multiples positions déplacées, le déplacement de l'élément d'entrée (20) consistant en une rotation de l'élément d'entrée (20) sur l'axe principal du dispositif de commande (1),
ledit dispositif de commande (1) étant conçu pour déterminer la position de l'élément d'entrée (20) en fonction du signal réfléchi, et
ledit dispositif de commande (1) étant conçu pour déterminer une entrée en fonction de la position de l'élément d'entrée (20) ;
et comprenant en outre au moins un des éléments suivants : un ressort mécanique conçu pour appliquer une force visant à renvoyer l'élément d'entrée (20) en position neutre, et au moins une paire d'aimants (14) conçue pour appliquer une force visant à renvoyer l'élément d'entrée (20) en position neutre.

2. Dispositif de commande (1) selon la revendication 1, ledit dispositif de commande (1) comprenant deux paires d'aimants.

3. Dispositif de commande (1) selon la revendication 1 ou 2, dans lequel l'élément d'entrée (20) comprend un réflecteur (13) agencé pour réfléchir le signal vers l'unité de détection (11b) lorsque l'élément d'entrée (20) est en position neutre ou en position déplacée.

4. Dispositif de commande (1) selon la revendication 1, 2 ou 3, dans lequel l'unité de commande (10) comprend un réflecteur (13) agencé pour réfléchir le signal vers l'unité de détection (11b) et l'élément d'entrée (20) comprend une portion non réfléchissante (16) conçue pour bloquer un reflet du signal lorsque l'élément d'entrée (20) est en position neutre ou en position déplacée.

5. Dispositif de commande (1) selon l'une quelconque des revendications précédentes, dans lequel l'entrée se rapporte à une valeur souhaitée de la caractéristique d'écoulement d'eau à commander.

6. Dispositif de commande (1) selon l'une quelconque des revendications précédentes, dans lequel l'entrée sert à passer en revue des options de menu fournies par le dispositif de commande (1).

7. Dispositif de commande (1) selon l'une quelconque des revendications précédentes, comprenant en outre une portion de couplage (17) conçue pour coupler le boîtier (15) et l'élément d'entrée (20).

8. Dispositif de commande (1) selon l'une quelconque des revendications précédentes, dans lequel l'élément d'entrée (20) est mobile par rapport à l'unité de commande (10) entre une position neutre et plus d'une position déplacée, de préférence deux positions déplacées, trois positions déplacées ou quatre positions déplacées.

9. Dispositif de commande (1) selon l'une quelconque des revendications précédentes, comprenant en outre une barrière (18a, 18b, 18c, 18d, 18e) conçue pour limiter un déplacement de l'élément d'entrée (20).

10. Dispositif de commande (1) selon l'une quelconque des revendications précédentes, dans lequel la caractéristique d'écoulement d'eau à commander est la température de l'écoulement d'eau et/ou le débit de l'écoulement d'eau.

11. Dispositif de commande (1) selon l'une quelconque des revendications précédentes, comprenant en outre un élément arrière (40) conçu pour limiter un déplacement de l'élément d'entrée (20).

12. Dispositif de commande (1) selon la revendication 11, ledit dispositif de commande comprenant un raccord de type baïonnette entre l'unité de commande (10) et l'élément arrière (40).

13. Dispositif de commande (1) selon l'une quelconque des revendications précédentes, dans lequel l'unité de commande (10) comprend des connecteurs mâles (55) assurant des moyens de raccordement électrique du dispositif de commande (1) à une source d'électricité.

14. Dispositif de commande (1) selon l'une quelconque des revendications précédentes, comprenant en outre une bande amovible (60) autour du boîtier (15).

15. Système en rapport avec l'eau comprenant un dispositif de commande (1) selon l'une quelconque des revendications 1 à 14.
